# EUROPÄISCHE PATENTANMELDUNG

(11) **EP 0 750 454 A2**
(43) Veröffentlichungstag der Anmeldung: **27.12.1996**
(21) Anmeldenummer: 96108001.7
(22) Anmeldetag: 20.05.1996
(51) Int. Cl.: H05K 13/00

(54) **Trägersystem für elektrische Bauelemente**

(30) Priorität: 22.06.1995 DE 29510169 U
(71) Anmelder: SIEMENS MATSUSHITA COMPONENTS GmbH & CO KG, 81541 München (DE)
(72) Erfinder: Lampl, Ewald, Dipl.-Ing., 8551 Wies (AT)
(74) Vertreter: Fuchs, Franz-Josef, Dr.-Ing.

(57) **Zusammenfassung**

Trägersystem für elektrische Bauelemente mit auf einem Trägerstreifen (1) angeordneten Befestigungselementen (2 bis 5),in denen Führungsnuten (3) vorgesehen sind, die so ausgebildet sind, daß in sie eingeführte Bauelementzuleitungsdrähte (6) kraftschlüssig gehalten sind.

## Beschreibung

Die vorliegende Erfindung betrifft ein Trägersystem für elektrische Bauelemente, insbesondere zweipolige elektrische Bauelemente wie Varistoren und Thermistoren, nach dem Oberbegriff des Schutzanspruchs 1.

Beispielsweise aus dem Datenbuch "Thermistoren", Ausgabe 1993, Seite 309 der Anmelderin ist ein Trägersystem für bedrahtete Bauelemente bekannt, bei dem Bauelemente während der Produktion und/oder während des Transportes zwischen Bauelementhersteller und Kunden über ihre Anschlußdrähte mittels eines Klebestreifens auf einem Trägerstreifen, beispielsweise einem Kartonträgerstreifen, fixiert werden. Dabei handelt es sich um eine formschlüssige Fixierung, bei der das Rastermaß, d. h. der Abstand zwischen den Anschlußdrähten schwierig einzuhalten ist.

Der vorliegenden Erfindung liegt die Aufgabe zugrunde, ein Trägersystem der in Rede stehenden Art anzugeben, mit dem eine exakte Einhaltung des Rastermaßes möglich ist.

Diese Aufgabe wird bei einem Trägersystem der eingangs genannten Art erfindungsgemäß durch die Merkmale des kennzeichnenden Teils des Patentanspruchs 1 gelöst.

Weiterbildungen der Erfindung sind Gegenstand von Unteransprüchen.

Die Erfindung wird nachfolgend anhand von Ausführungsformen gemäß den Figuren der Zeichnungen näher erläutert. Es zeigt:
- Figur 1: eine erste Ausführungsform eines erfindungsgemäßen Trägersystems;
- Figur 2: einen Ausschnitt eines Trägerstreifens mit darauf vorgesehenen Befestigungsvorrichtungen des Trägersystems nach Figur 1;
- Figur 3: eine zweite Ausführungsform eines erfindungsgemäßen Trägersystems; und
- Figur 4: einen Ausschnitt eines Trägerstreifens mit darauf vorgesehenen Befestigungsvorrichtungen eines Trägersystems nach Figur 3.

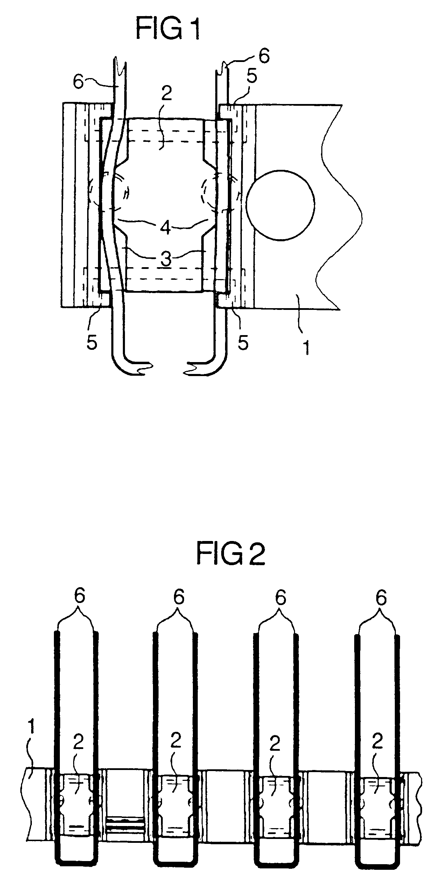

Bei der erfindungsgemäßen Ausführungsform eines Trägersystems nach Figur 1 ist auf einem Trägerstreifen 1 eine Befestigungsvorrichtung 2 vorgesehen, die durch ein auf dem Trägerstreifen 1 angeordnetes Befestigungselement 2 mit darin vorgesehenen Führungsnuten 3 gebildet sind. Die Führungsnuten 3 sind so ausgebildet, daß in sie eingeführte Zuleitungsdrähte 6 von nicht dargestellten bedrahteten elektrischen Bauelementen kraftschlüssig gehalten sind. Die Führungsnuten 3 sind auf ihrer vom Trägerstreifen 1 abgewandten Seite offen und weisen an einer Nutenwand Ansätze 4 auf, welche die Führungsnuten 3 zur elastischen Verformung von in sie eingeführten Zuleitungsdrähten 6 auf einem Teil ihrer Länge verengen.

Die Zuleitungsdrähte 6 werden während des Bestückungsvorganges durch entsprechende Werkzeuge, z. B. einen Bestückungsschuh, elastisch verformt und in die Führungsnuten 3 geklemmt. Dabei werden die Zuleitungsdrähte 6 derart elastisch geklemmt, daß sie durch Reibung in Längsrichtung Kräfte übertragen können.

Weiterhin sind an der Befestigungsvorrichtung 2 über die Führungsnuten 3 greifende Ansätze 5 vorgesehen, welche die Zuleitungsdrähte 6 zusätzlich halten.

Figur 2 zeigt einen Ausschnitt aus einem Trägerstreifen 1 mit darauf vorgesehenen Befestigungsvorrichtungen 2 nach Figur 1, in die Zuleitungsdrähte 6 eingeführt sind.

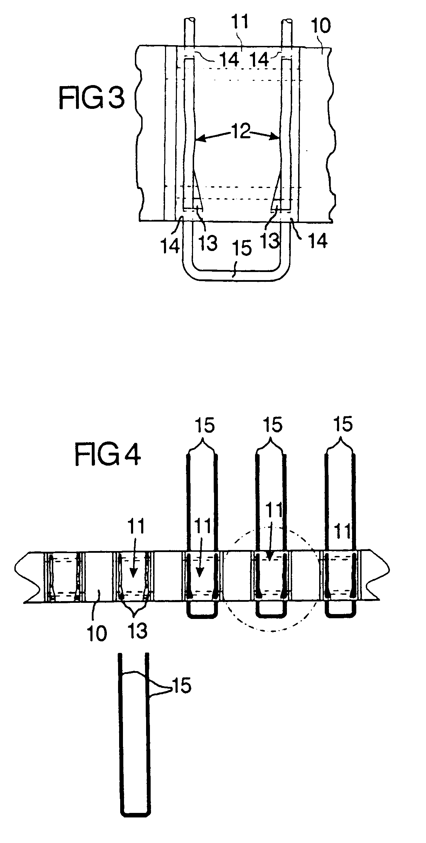

Bei der erfindungsgemäßen Ausführungsform nach den Figuren 3 und 4 ist eine Befestigungsvorrichtung 11 vorgesehen, in der Führungsnuten 13 quer zu ihrer Längsrichtung durch nach innen gerichtete Einbuchtungen 12 so geformt sind, daß in sie eingeführte Zuleitungsdrähte 15 elastisch verformt werden. Die Drähte werden dabei derart in die Führungsnuten 13 geschoben, daß sie elastisch vorgespannt bleiben und in Längsrichtung Kräfte übertragen können.

Auch bei dem Trägersystem nach den Figuren 3 und 4 sind gemäß Figur 3 über die Führungsnuten 13 greifende Ansätze 14 vorgesehen, welche die Zuleitungsdrähte 15 zusätzlich haltern.

Figur 4 zeigt einen Ausschnitt aus einem Trägerstreifen 10 mit darauf angeordneten Befestigungsvorrichtungen 11, Führungsnuten 13 in den Befestigungselementen 11 sowie in die Führungsnuten 13 eingeführte Zuleitungsdrähte 15.

Die Trägerstreifen 1 nach den Figuren 1 und 2 bzw. 10 nach den Figuren 3 und 4 können starr oder flexibel ausgebildet sein.

Das erfindungsgemäße Trägersystem besitzt den Vorteil, daß das Rastermaß durch die Führungsnuten 3 nach den Figuren 1 und 2 bzw. 13 nach den Figuren 3 und 4 exakt formschlüssig fixiert wird. Darüberhinaus besteht dabei die Möglichkeit, die Zuleitungsdrähte 6 bzw. 15 in Längsrichtung zu verschieben und bei der Bauelementeherstellung den einzelnen Bearbeitungsschritten anzupassen. Die Trägerstreifen mit den darauf befindlichen Befestigungsvorrichtungen können nach Ausziehen der Zuleitungsdrähte wieder verwendet werden.

## Patentansprüche

1. Trägersystem für elektrische Bauelemente, insbesondere zweipolige bedrahtete elektrische Bauelemente, mit einem Trägerstreifen (1; 10), auf dem Bauelemente an ihren Zuleitungsdrähten (6; 15) mittels Befestigungsvorrichtungen (2 bis 5; 11 bis 14) fixierbar sind,
**dadurch gekennzeichnet,**
daß die Befestigungsvorrichtungen (2 bis 5; 11 bis 14) durch auf dem Trägerstreifen (1; 11) angeordnete Befestigungselemente (2; 11) mit darin vorgesehenen Führungsnuten (3; 13) gebildet sind und daß die Führungsnuten (3; 13) so ausgebildet sind, daß in sie eingeführte Zuleitungsdrähte (6; 15) kraftschlüssig gehalten sind.

2. Trägersystem nach Anspruch 1,
**dadurch gekennzeichnet,**
daß die Führungsnuten (3; 13) so ausgebildet sind, daß in sie eingeführte Zuleitungsdrähte (6; 15) elastisch geklemmt werden.

3. Trägersystem nach Anspruch 1 und 2,
**dadurch gekennzeichnet,**
daß die Führungsnuten (3) auf ihrer vom Trägerstreifen (1) abgewandten Seite offen sind und an einer Nutenwand Ansätze (4) aufweisen, welche die Führungsnuten (3) zur elastischen Verformung von in sie eingeführten Zuleitungsdrähten (6) auf einem Teil ihrer Länge verengen.

4. Trägersystem nach Anspruch 1 und 2,
**dadurch gekennzeichnet,**
daß die Führungsnuten (13) quer zu ihrer Längsrichtung so geformt sind, daß in sie eingeführte Zuleitungsdrähte (15) elastisch verformt werden.

5. Trägersystem nach Anspruch 4,
**dadurch gekennzeichnet,**
daß die Führungsnuten (13) einander zugekehrte Ausbuchtungen (12) aufweisen.

6. Trägersystem nach einem der Ansprüche 1 bis 5,
**gekennzeichnet durch** über die Führungsnuten (3; 13) greifende Ansätze (5; 14) an den Befestigungselementen (2; 11).

7. Trägersystem nach einem der Ansprüche 1 bis 6,
**dadurch gekennzeichnet,**
daß der Trägerstreifen (1; 11) starr ist.

8. Trägerstreifen nach einem der Ansprüche 1 bis 6,
**dadurch gekennzeichnet,**
daß der Trägerstreifen (1; 11) flexibel ist.
